Europäisches Patentamt

European Patent Office

Office européen des brevets

(11) Publication number: **0 237 725**
**A1**

# EUROPEAN PATENT APPLICATION

(21) Application number: **87100852.0**

(22) Date of filing: **22.01.87**

(51) Int. Cl.⁴: **H01L 23/30**

(30) Priority: **20.03.86 US 842082**

(43) Date of publication of application:
**23.09.87 Bulletin 87/39**

(84) Designated Contracting States:
**BE DE FR GB IT NL**

(71) Applicant: **GTE Products Corporation**
**100 West 10th Street**
**Wilmington, DE 19801(US)**

(72) Inventor: **Johnson, Richard E.**
**R.F.D. 4 Box 6**
**Jamestown New York 14701(US)**

(74) Representative: **Patentanwälte Grünecker,**
**Kinkeldey, Stockmair & Partner**
**Maximilianstrasse 58**
**D-8000 München 22(DE)**

(54) **Plastic integrated circuit package having reduced moisture absorbtion.**

(57) Moisture penetration into plastic IC packages is inhibited by coating the broad upper and lower surfaces thereof with metal, preferably , aluminum.

# PLASTIC INTEGRATED CIRCUIT PACKAGE HAVING REDUCED MOISTURE ABSORBTION

## Technical Field

This invention relates to integrated circuit (IC) packages and more particularly to such packages formed of plastic.

## Background Art

IC packages are conventionally formed of either ceramic or plastic materials which mount an IC chip and the suitable lead-ins therefor. While the ceramic packages are more expensive than those formed of plastic, the ceramic packages are often specified for use in hostile environments, particularly those involving atmospheres of high moisture content, because of the hermetic nature of the ceramic and its relative imperviousness to moisture penetration.

Accordingly, it is the general practice to use plastic packages only in those areas where moisture is not a problem.

## Disclosure Of The Invention

It is, therefore, an object of this invention to obviate the disadvantages of the prior art.

It is another object of the invention to enhance IC packages.

Yet another object of the invention to increase the environmental protection of plastic IC packages.

These objects are accomplished, in one aspect of the invention, by a plastic IC package which has its upper and lower surfaces covered by a substantially moisture impervious layer. In a preferred embodiment the layers are metal.

The package thus provided is useable in environments previously restricted to ceramic packages, at a cost that is much less than the ceramic package.

## Brief Description Of The Drawings

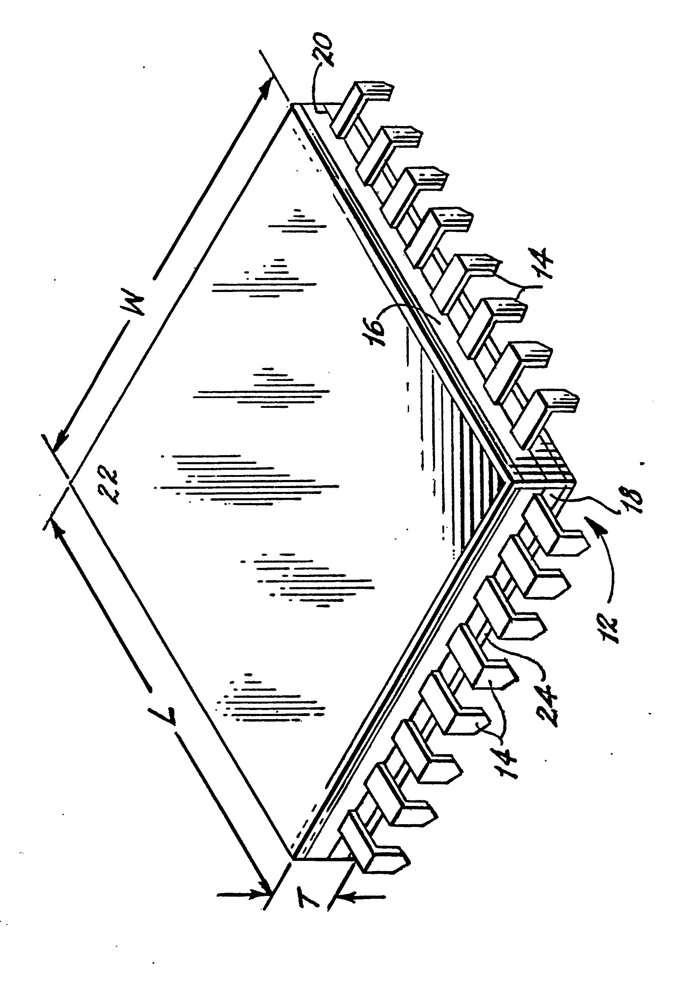

The single figure is a perspective view of an IC package incorporating the invention.

## Best Mode For Carrying Out The Invention

For a better understanding of the present invention, together with other and further objects, advantages and capabilities thereof, reference is made to the following specification and appended claims taken in conjunction with the above-described drawing.

Referring now to the drawing with greater particularity, there is shown an IC package 10 formed of a suitable plastic material, such as Ultem 2210, available from the General Electric Company.

The package 10 comprises a body 12 which encapsulates an IC chip (not shown) and suitable electrical lead-ins 14 which project from body 12 for connection to external circuitry.

The body 12, in the illustration, is formed of upper and lower halves 16 and 18 respectively, which are sealed together at a jointure 20, from which the lead-ins 14 exit.

Body 12 has a given length L and width W and a thickness T which is substantially less than either L or W, which are usually equal.

Moisture ingress through the thickness T is inhibited by applying to the upper surface and the lower surface of body 12 a substantially moisture impervious layer 22 and 24 respectively.

It is noted that plastic packages as described herein have two moisture paths to the center where the IC chip is placed. The first of these moisture paths is along the lengths of the lead-ins 14 and is so long that a problem therewith is seldom presented. A shorter path, however, exists through the thickness of the body and it is this latter path that the layer 22 and 24 inhibit. The inhibiting action should be sufficient to make the thickness path at least equal in time to the long moisture path, thus extending the lifetime for the IC chip in a plastic package.

The moisture impervious layers are preferably metal, with aluminum or copper being extremely suitable.

The metal layers can be applied by evaporation deposition, sputtering or plating on the plastic surfaces.

Additionally, thin metal layers; i.e., 0.003 inches thick, can be applied by means of a suitable moisture impervious adhesive, such as Scotch Brand #468, available from Reid Associates, Inc.

Thus, inexpensive plastic IC packages employing the invention described herein can be utilized in environments where their use was previously contra-indicated.

While there have been shown and described what are at present considered to be the preferred embodiments of the invention, it will be apparent to those skilled in the art that various changes and modifications can be made herein without departing from the scope of the invention as defined by the appended claims.

## Claims

1. A plastic, integrated circuit package for use in environments having a high moisture content, said package comprising:
a plastic body having a given length and width and a thickness much less than said given length and width, said thickness existing between upper and lower surfaces of said body defined by said given length and width; and
a substantially moisture impervious layer fixedly attached to said upper and lower surfaces.

2. The package of Claim 1 wherein said substantially moisture impervious layers are metal.

3. The package of Claim 2 wherein said metal is selected from aluminum and copper.

4. The package of Claim 2 wherein said metal layers are fixedly attached to said upper and lower surfaces by a substantially moisture insoluble adhesive.

5. The package of Claim 2 wherein said metal layers are deposited by an evaporative deposition process.

6. The package of Claim 2 wherein said metal layers are deposited by sputtering.

7. A plastic integrated circuit package for use in environments having a high moisture content, said package comprising:
a plastic body having a given length and width, said body being formed from upper and lower halves sealed together;
a plurality of metal lead-ins projecting from said body at the jointure of said upper and lower halves, said lead-ins inherently defining a long moisture path from the outside edge of said body to the interior thereof;
said body further having a thickness existing between upper and lower surfaces of said body, said thickness being much less than either said given length and width and inherently defining a short moisture path through either of said surfaces to the interior of said body; and
a substantially moisture impervious layer fixedly attached to said upper and lower surfaces, said moisture impervious layers effectively making said short moisture path at least equal to said long moisture path.

8. The package of Claim 7 wherein said layers are metal

9. The package of Claim 8 wherein said metal is selected from aluminum and copper.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN, vol. 10, no. 79 (E-391)[2136], 28th March 1986; & JP-A-60 224 249 (HITACHI MAIKURO COMPUTER ENGINEERING K.K.) 08-11-1985 * Abstract * | 1,7 | H 01 L 23/30 |
| A | PATENT ABSTRACT OF JAPAN, vol. 9, no. 305 (E-363)[2028], 3rd December 1985; & JP-A-60 143 650 (MATSUSHITA DENKI SANGYO K.K.) 29-07-1985 * Abstract * | 1-4,7-9 | |
| A | PATENT ABSTRACTS OF JAPAN, vol. 9, no. 147 (E-323)[1870], 21st June 1985; & JP-A-60 28 251 (NIPPON DENKI K.K.) 13-02-1985 * Abstract * | 1-3,7-9 | |
| A | DE-A-2 543 968 (LICENTIA) * Figures 1,2; page 11, line 17 - page 13, line 24 * | 1,2,7,8 | TECHNICAL FIELDS SEARCHED (Int. Cl.4) H 01 L |
| A | PATENT ABSTRACTS OF JAPAN, vol. 6, no. 247 (E-146)[1125], 7th December 1982; & JP-A-57 145 346 (KIYUUSHIYUU NIPPON DENKI K.K.) 08-09-1982 * Abstract * | | |

-/-

The present search report has been drawn up for all claims

| Place of search | Date of completion of the search | Examiner |
|---|---|---|
| THE HAGUE | 12-06-1987 | CAMPLING N.C.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

| **DOCUMENTS CONSIDERED TO BE RELEVANT** | | | Page 2 |
|---|---|---|---|
| Category | Citation of document with indication, where appropriate, of relevant passages | Relevant to claim | CLASSIFICATION OF THE APPLICATION (Int. Cl.4) |
| A | PATENT ABSTRACTS OF JAPAN, vol. 10, no. 113 (E-399)[2170], 26th April 1986; & JP-A-60 247 951 (SUWA SEIKOSHA K.K.) 07-12-1985 * Abstract * ----- | 1-3,7-9 | |
| | | | **TECHNICAL FIELDS SEARCHED (Int. Cl.4)** |

The present search report has been drawn up for all claims

| Place of search | Date of completion of the search | Examiner |
|---|---|---|
| THE HAGUE | 12-06-1987 | CAMPLING N.C.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82